(19) Europäisches Patentamt
European Patent Office
Office européen des brevets

(11) **EP 1 639 507 B1**

(12) **EUROPÄISCHE PATENTSCHRIFT**

(45) Veröffentlichungstag und Bekanntmachung des Hinweises auf die Patenterteilung:
**09.07.2008 Patentblatt 2008/28**

(21) Anmeldenummer: **04705780.7**

(22) Anmeldetag: **28.01.2004**

(51) Int Cl.:
***G06F 17/50*** *(2006.01)*

(86) Internationale Anmeldenummer:
**PCT/EP2004/000737**

(87) Internationale Veröffentlichungsnummer:
**WO 2004/068372 (12.08.2004 Gazette 2004/33)**

(54) **VERFAHREN UND VORRICHTUNG ZUR FORMALEN SCHALTUNGSVERIFIKATION**

METHOD AND DEVICE FOR THE FORMAL VERIFICATION OF A CIRCUIT

PROCEDE ET DISPOSITIF DE VERIFICATION FORMELLE DE CIRCUIT

(84) Benannte Vertragsstaaten:
**AT BE BG CH CY CZ DE DK EE ES FI FR GB GR HU IE IT LI LU MC NL PT RO SE SI SK TR**

(30) Priorität: **30.01.2003 DE 10303684**

(43) Veröffentlichungstag der Anmeldung:
**29.03.2006 Patentblatt 2006/13**

(73) Patentinhaber: **Onespin Solutions GmbH
80339 München (DE)**

(72) Erfinder: **BUSCH, Holger
85649 Brunnthal (DE)**

(74) Vertreter: **Hofmann, Harald
Sonnenberg Fortmann
Postfach 33 08 65
80068 München (DE)**

(56) Entgegenhaltungen:
**US-B1- 6 499 132**

- **BROWNE M C ET AL: "AUTOMATIC VERIFICATION OF SEQUENTIAL CIRCUITS USING TEMPORAL LOGIC" IEEE TRANSACTIONS ON COMPUTERS, IEEE INC. NEW YORK, US, Bd. C-35, Nr. 12, 1. Dezember 1986 (1986-12-01), Seiten 1035-1044, XP000648578 ISSN: 0018-9340**

- **NARENDRAN P ET AL: "Formal verification of the Sobel image processing chip" PROCEEDINGS OF THE DESIGN AUTOMATION CONFERENCE. ANAHEIM, JUNE 12 - 15, 1988, PROCEEDINGS OF THE DESIGN AUTOMATION CONFERENCE (DAC), NEW YORK, IEEE, US, Bd. CONF. 25, 12. Juni 1988 (1988-06-12), Seiten 211-217, XP010012996 ISBN: 0-8186-0864-1**

- **KONO S: "A combination of clasual and non clausal temporal logic program" PROCEEDINGS, EXECUTABLE MODAL AND TEMPORAL LOGICS. IJCAI '93 WORKSHOP, PP.40-57 - MANUSCRIPT, [Online] 18. August 1993 (1993-08-18), Seiten 1-16, XP002289219 CHAMBERY, FRANCE ISBN: 3-540-58976-7 Gefunden im Internet: URL:http:// citeseer.ist.psu.edu/370092.htm l> [gefunden am 2004-07-20]**

- **PELIN A ET AL: "The Knuth-Bendix algorithm in parallel architecture" IEEE PROCEEDINGS 1989 SOUTHEASTCON, 9. April 1989 (1989-04-09), Seiten 645-648, XP010082410**

- **JABRI M A ED - INSTITUTE OF ELECTRICAL AND ELECTRONICS ENGINEERS: "Brel-a PROLOG knowledge-based system shell for VLSI CAD" PROCEEDINGS OF THE ACM / IEEE DESIGN AUTOMATION CONFERENCE. ORLANDO, JUNE 24 - 28, 1990, PROCEEDINGS OF THE ACM/IEEE DESIGN AUTOMATION CONFERENCE (DAC), NEW YORK, IEEE, US, Bd. CONF. 27, 24. Juni 1990 (1990-06-24), Seiten 272-277, XP010079469 ISBN: 0-89791-363-9**

- **FILKORN T ET AL: "Experiences from a large industrial circuit design application" LOGIC PROGRAMMING. PROCEEDINGS OF THE 1991 INTERNATIONAL SYMPOSIUM, 1991, Seiten 581-595, XP001182368 CAMBRIDGE, MA, USA ISBN: 0-262-69147-7**
- **CAU A ET AL: "A compositional framework for hardware/software co-design" DES. AUTOM. EMBEDDED SYST. (NETHERLANDS), DESIGN AUTOMATION FOR EMBEDDED SYSTEMS, JULY 2002, KLUWER ACADEMIC PUBLISHERS, NETHERLANDS, Bd. 6, Nr. 4, Juli 2002 (2002-07), Seiten 367-399, XP009033732 ISSN: 0929-5585**
- **BJORNER N S ET AL: "Deductive verification of real-time systems using STeP" TRANSFORMATION-BASED REACTIVE SYSTEMS DEVELOPMENT. 4TH INTERNATIONAL AMAST WORKSHOP ON REAL-TIME SYSTEMS AND CONCURRENT AND DISTRIBUTED SOFTWARE, ARTS '97., Bd. 253, Nr. 1, 21. Mai 1997 (1997-05-21), Seiten 27-60, XP002289220 PALMA DE MALLORCA, SPAIN ISSN: 0304-3975**
- **LEESER M E: "REASONING ABOUT THE FUNCTION AND TIMING OF INTEGRATED CIRCUITS WITHINTERVAL TEMPORAL LOGIC" IEEE TRANSACTIONS ON COMPUTER AIDED DESIGN OF INTEGRATED CIRCUITS AND SYSTEMS, IEEE INC. NEW YORK, US, Bd. 8, Nr. 12, 1. Dezember 1989 (1989-12-01), Seiten 1233-1246, XP000126836 ISSN: 0278-0070**

**Beschreibung**

Die vorliegende Erfindung betrifft ein Verfahren sowie eine zur Durchführung des Verfahrens eingerichtete Vorrichtung zur formalen Verifikation einer Digitalschaltung.

Insbesondere richtet sich die vorliegende Erfindung auf die Verifikation von Entwürfen einer digitalen Schaltung, die auf Grund deren komplexen Verhaltens nicht ausreichend durch Simulation getestet werden kann. In derartigen Fällen bedient man sich meist einer mathematisch basierten Modellprüfung, wobei formale Eigenschaften der Schaltung vorgegeben werden und formal überprüft wird, ob das aktuelle Schaltungsmodell diese Eigenschaft aufweist. Bei der Überprüfung formaler Eigenschaften einer Digitalschaltung kann als Ergebnis stehen, dass eine bestimmte Eigenschaft zutrifft, nicht zutrifft oder dass nicht überprüfbar ist, ob die Eigenschaft zutrifft oder nicht.

Eine Eigenschaft im Sinne der vorliegenden Erfindung besitzt eine Voraussetzung und eine Behauptung. Eine Eigenschaft ist zutreffend bzw. die Schaltung besitzt diese Eigenschaft, wenn bei Vorliegen der Voraussetzung die Behauptung eintrifft bzw. zutrifft, wobei sowohl die Voraussetzung als auch die Behauptung der Eigenschaft Zustandsbeschreibungen der Schaltung unter Berücksichtigung der Zeit bzw. relativer Zeitbezüge sind. Dabei stellt eine derartige Schaltungsbeschreibung den Zustand der Schaltung nicht vollständig dar, sondern umfasst nur einzelne Zustandsprädikate. Ein solches einzelnes Zustandsprädikat kann beispielsweise den logischen Zustand einer Signalleitung innerhalb der Schaltung, den Inhalt eines Registers, oder eine Relation zwischen mehreren Signalen festlegen. In der Regel werden Zustandsbeschreibungen nur den Zustand von einigen wenigen Teilen der Schaltung wiedergeben.

Eine Zustandsbeschreibung als Bestandteil einer Eigenschaft besitzt dabei auch eine zeitliche Komponente, so dass nicht nur ein Schaltungszustand zu einem bestimmten Zeitpunkt, sondern auch über eine bestimmte Anzahl von Zeitschritten bzw. über eine bestimmte Zeitdauer erfasst sind. Damit können insbesondere Wechsel von logischen Zuständen bestimmter Signale oder eines Registerinhalts zusammen mit deren zeitlicher relativer Lage erfasst werden.

Grundsätzlich entsteht bei der Definition solcher formaler Eigenschaften eine formale Beschreibung der Schaltung, die abstrakt ist und viel weniger Details als der komplette Schaltungsentwurf besitzt.

Bei der Formulierung einer Eigenschaft wird eine Voraussetzung definiert, die ein bestimmtes zeitliches Verhalten ausgewählter Schaltungsteile über die Zeit beschreibt, und wird eine Behauptung formuliert, die ebenfalls das zeitliche Verhalten ausgewählter Schaltungsteile beschreibt.

Dabei stehen Voraussetzung und Behauptung einer Eigenschaft in der Regel in einer festen zeitlichen Beziehung zueinander, so dass die von der Behauptung einer Eigenschaft definierten Zustandsänderungen zeitlich definiert in Bezug auf die Zustandsänderungen in der Voraussetzung auftreten, wenn die Eigenschaft zutrifft. Die Zeitbereiche, die von der Voraussetzung und der Behauptung einer Eigenschaft aufgespannt werden, überlappen sich in der Regel. Der gesamte, von einer Eigenschaft aufgespannte Zeitrahmen wird als Intervall der Eigenschaft bezeichnet. Eine Beobachtung des Zustands der Schaltung über dieses Intervall einer Eigenschaft ist für diese bestimmte Eigenschaft nicht erforderlich.

Die Voraussetzung und die Behauptung einer Eigenschaft kann mit Begriffen aus der ITL (Interval Temporal Logic) definiert werden. Als zeitlicher Bezugspunkt kann in einer Eigenschaft ein Bezeichner für einen bestimmten Zeitpunkt eingeführt werden, der beispielsweise t ist. Die Beschreibung einzelner Zustände bzw. Zustandsänderungen geschieht dann in Bezug auf diesen Zeitpunkt, wobei insbesondere die relative Lage mit Hilfe von Zeitschritten ausgedrückt wird, beispielsweise wäre ein fünf Zeitschritte hinter dem Referenzzeitpunkt gelegener Zeitpunkt mit t+5 gekennzeichnet.

Der vorliegenden Erfindung liegt die Aufgabe zu Grunde, ein Verfahren sowie eine zur Durchführung des Verfahrens eingerichtete Vorrichtung zu schaffen, mit denen eine formale Verifikation einer digitalen Schaltung mit geringem Aufwand und auch für lange Intervalle von Eigenschaften durchgeführt werden kann.

Erfindungsgemäss wird diese Aufgabe durch ein Verfahren mit den Merkmalen des Anspruchs 1 bzw. eine Vorrichtung mit den Merkmalen des Anspruchs 13 gelöst. Die Unteransprüche definieren jeweils bevorzugte und vorteilhafte Ausführungsformen der vorliegenden Erfindung.

Erfindungsgemäss wird von Hilfseigenschaften ausgegangen, die insbesondere bereits formal bewiesene Eigenschaften sind und somit das Verhalten der betreffenden digitalen Schaltung un- ter den jeweiligen Voraussetzungen der einzelnen Hilfseigenschaften verlässlich beschreiben. Weiterhin wird eine Startvoraussetzung vorgegeben, die ebenso eine Zustandsbeschreibung der Schaltung unter Berücksichtigung der Zeit ist. Die Startvoraussetzung für die Schaltung entspricht daher dem Wesen nach einer Voraussetzung einer Hilfseigenschaft.

Weiterhin ist eine akkumulierte Voraussetzung definiert, die ebenso wie die Startvoraussetzung eine Zustandsbeschreibung der digitalen Schaltung unter Berücksichtigung der Zeit ist. Die akkumulierte Voraussetzung wird wiederholt in einer Voraussetzungsprüfung dahingehend geprüft, ob sie die Voraussetzung einer begrenzt zeitverschobenen Hilfseigenschaft umfasst. Wenn dies der Fall ist, wird diese Hilfseigenschaft aktiviert bzw. wird die Behauptung dieser Hilfseigenschaft der akkumulierten Voraussetzung hinzugefügt. Die Behauptung dieser aktivierten Hilfseigenschaft stellt somit die Folge dar, die auf Grund des Vorliegens der Voraussetzung für diese Hilfseigenschaft eintritt.

Vorteilhafterweise wird die Voraussetzungsprüfung jedes Mal durchgeführt, wenn sich die akkumulierte Voraussetzung geändert hat, da in diesem Fall die akkumulierte Voraussetzung inzwischen neue Voraussetzungen von Hilfseigenschaften umfassen könnte, so dass diese aktiviert werden könnten.

Auf diese Weise wird iterativ durch Anwendung der Hilfseigenschaften die akkumulierte Voraussetzung weiterentwickelt.

Bei dem Weiterentwickeln der akkumulierten Voraussetzung muss in der Regel auch berücksichtigt werden, in welcher zeitlichen Lage in Bezug auf die aktuelle akkumulierte Voraussetzung die Voraussetzung für eine Hilfseigenschaft gegebenenfalls erfüllt sind und in welcher zeitlichen Lage relativ zur akkumulierten Voraussetzung die Behauptung einer aktivierten Hilfseigenschaft eintritt, um die Behauptung einer aktivierten Hilfseigenschaft mit dem richtigen zeitlichen Bezug zu der akkumulierten Voraussetzung hinzufügen zu können.

Vorteilhafterweise werden Zwischenbeziehungen zwischen den einzelnen Hilfseigenschaften ermittelt, die angeben, wie sich das Vorliegen der Voraussetzung einer Hilfseigenschaft auf das Vorliegen der Voraussetzung einer anderen Hilfseigenschaft auswirkt. Mit anderen Worten ausgedrückt, beschreibt eine solche Zwischenbeziehung, ob aus der Aktivierung einer Hilfseigenschaft in Bezug auf die Aktivierung wenigstens einer anderen Hilfseigenschaft in geeigneter relativer Zeitverschiebung Aussagen getroffen werden können. Eine solche Abhängigkeit kann sich auf verschiedene Weisen ergeben. Beispielsweise können die Voraussetzungen zweier Hilfseigenschaften gleich sein, so dass bei der Aktivierung einer Hilfseigenschaft automatisch auch die andere Hilfseigenschaft aktiviert wird. In einem derartigen Fall könnten die beiden Hilfseigenschaften jedoch auch zu einer einzigen Hilfseigenschaft mit gleicher Voraussetzung zusammengefasst werden, indem die beiden Behauptungen der beiden Hilfseigenschaften addiert werden.

Eine Abhängigkeit unter zwei Hilfseigenschaften kann sich auch dadurch ergeben, dass die Voraussetzung und die Behauptung einer ersten Hilfseigenschaft zusammengenommen die Voraussetzung einer zweiten Hilfseigenschaft umfassen, so dass bei Aktivierung der ersten Hilfseigenschaft und Hinzufügung der Behauptung der ersten Hilfseigenschaft zur akkumulierten Voraussetzung automatisch die Voraussetzung für die zweite Hilfseigenschaft gegeben ist und somit diese aktiviert wird.

Daneben sind auch Zwischenbeziehungen möglich, die anzeigen, dass die Aktivierung einer zweiten Hilfseigenschaft bei Aktivierung einer ersten Hilfseigenschaft ausgeschlossen ist, wobei dieses Ausgeschlossensein der Aktivierung der zweiten Hilfseigenschaft auch in Abhängigkeit einem bestimmten zeitlichen Bezug zwischen den beiden Hilfseigenschaften angezeigt sein kann. Dieses sich gegenseitig Ausschließen kann eintreten, weil die Voraussetzungen der beiden Hilfseigenschaften sich ausschließen oder weil die Behauptung der ersten Hilfseigenschaft die Voraussetzung für die zweite Hilfseigenschaft ausschließt. Solche einmal vorab ermittelten Zwischenbeziehungen zwischen Hilfseigenschaften ersparen im weiteren Verlauf individuelle Prüfungen, ob Voraussetzungen von Hilfseigenschaften aus der akkumulierten Voraussetzung folgen oder dazu im Widerspruch stehen.

Sobald die akkumulierte Voraussetzung die Voraussetzung einer Hilfseigenschaft umfasst, wird diese Hilfseigenschaft aktiviert. Zu welchem Zeitpunkt dies geschieht und zu welchem Zeitpunkt die Behauptung der aktivierten Hilfseigenschaft eintritt, hängt von der relativen zeitlichen Lage in Bezug auf die akkumulierte Voraussetzung der Zustandsbeschreibungen der Hilfseigenschaft ab. In einer vorteilhaften Ausführungsform der vorliegenden Erfindung werden die zeitlichen Bezüge der Aktivierung oder Nichtaktivierung von Hilfseigenschaften in einer Aktivierungsmatrix dargestellt. In dieser Aktivierungsmatrix ist für jede Hilfseigenschaft für wenigstens einen Zeitverschiebungsschritt angegeben, ob die jeweilige Hilfseigenschaft aktiviert oder deaktiviert ist oder ob darüber keine Aussage möglich ist bzw. es noch offen ist und bei veränderter akkumulierter Voraussetzung es noch möglich ist, dass die Hilfseigenschaft für den jeweiligen Zeitverschiebungsschritt aktiviert oder deaktiviert werden kann. Die vorteilhafte Einbeziehung der Zeitverschiebung bzw. des zeitlichen Bezugs zu der akkumulierten Voraussetzung ist dann erforderlich, wenn die akkumulierte Voraussetzung ebenso wie die Voraussetzungen der Hilfseigenschaften den Schaltungszustand über eine bestimmte Zeitdauer darstellen, und somit die Angabe, dass eine bestimmte Hilfsfunktion bei der aktuellen akkumulierten Voraussetzung aktiviert oder deaktiviert ist, vorteilhafterweise auch die Angabe des Zeitpunkts bzw. des zeitlichen Bezugs enthält, zu dem die Aktivierung oder Deaktivierung vorliegt.

Dazu kann in der Aktivierungsmatrix für jede Hilfseigenschaft ein Zeilenvektor vorgegeben werden, dessen einzelne Elemente den Aktivierungszustand der Hilfseigenschaft für eine bestimmte Zeitverschiebung bzw. einen bestimmten zeitlichen Bezug zur akkumulierten Voraussetzung angeben, wobei die Zeitverschiebung zeitdiskret ist und durch eine bestimmte Anzahl von Zeitschritten dargestellt werden kann, die beispielsweise dem Systemtakt der Digitalschaltung entsprechen können. Der Aktivierungszustand für eine bestimmte Hilfseigenschaft für eine bestimmte Zeitverschiebung, der auch als Offset der Hilfseigenschaft gegenüber der akkumulierten Voraussetzung aufgefasst werden kann, kann die Angaben Aktiviert, Deaktiviert oder Offen beinhalten, wobei die Angabe Offen ausdrückt, dass für diese Hilfseigenschaft und diese Zeitverschiebung keine Aussage darüber möglich ist, ob die Hilfseigenschaft aktiviert oder deaktiviert ist. Die Anzeige Aktiviert bedeutet, dass die jeweilige Hilfseigenschaft zu der betreffenden Zeitverschiebung aktiviert wird. Die Angabe Deaktiviert bedeutet entsprechend, dass die Hilfseigenschaft für diese Zeitverschiebung deaktiviert ist und die Angabe Offen bedeutet, dass nach dem aktuellen Stand der akkumulierten Voraussetzung es möglich ist, dass bei der betreffenden Zeitverschiebung abhängig von der weiteren Entwicklung der akkumulierten Voraussetzung die Hilfseigenschaft aktiviert oder auch deaktiviert werden kann.

Sobald für eine bestimmte Hilfseigenschaft die Aussage Aktiviert in der Aktivierungsmatrix getroffen wird, wird die Behauptung dieser Hilfseigenschaft an zeitlich richtiger Stelle zu der akkumulierten Voraussetzung hinzugefügt. Dabei wird vorteilhafterweise sichergestellt, dass der Eintrag Aktiviert in der Aktivierungsmatrix nur einmal zu dem Hinzufügen der Behauptung der jeweiligen Hilfseigenschaft führt. Dies schließt jedoch nicht aus, dass mit einer anderen Zeitverschiebung die gleiche Hilfseigenschaft noch einmal aktiviert werden kann.

Bei der Durchführung des Verfahrens werden somit gleichermaßen die akkumulierte Voraussetzung und die Aktivierungsmatrix weiterentwickelt, wobei bei jedem erfolgten Eintrag des Aktivierungszustand Aktiviert die entsprechende Hilfseigenschaft aktiviert und deren Behauptung in die akkumulierte Voraussetzung aufgenommen wird.

Tritt der Fall ein, dass keine Hilfseigenschaft mehr aus der akkumulierten Voraussetzung allein heraus aktiviert werden kann, werden anhand vorgegebener Fallunterscheidungsregeln automatisch Unterfälle generiert, bei denen jeweils die akkumulierte Voraussetzung getrennt mit der jeweiligen Bedingung des Unterfalls angereichert wird. Damit teilt sich das Beweisziel und die Aktivierungsmatrix entsprechend der Zahl der Unterfälle. Für jeden Unterfall wird dabei eine eigene akkumulierte Voraussetzung und eine eigene Aktivierungsmatrix geführt. Dieses Verfahren wird nur dann eingesetzt, wenn dabei Hilfsregeln aktiviert werden.

Das Verfahren terminiert je nach Beweisaufgabe, wenn die Behauptung zu Wahr oder Falsch reduziert worden ist, wenn auch mit Fallunterscheidungen keine Aktivierung zeitverschobener Hilfseigenschaften mehr erreicht wird, wenn alle noch aktivierbaren Zeitverschiebungen von Hilfseigenschaften außerhalb des Zeitfensters eines Beweisziels liegen, oder wenn die Aktivierungsmatrix für einen Zeitschritt einen Zustand annimmt, der identisch zu einem früheren Zeitschritt bereits vorliegt, ohne dass eine Reduktion der Behauptung eines Beweiszieles stattfindet, so dass lediglich eine bereits vorhandene Teilkette von Hilfseigenschaft zeitverschoben dupliziert würde.

Die einzelnen Hilfseigenschaften können vor der Verwendung in dem erfindungsgemäßen Verfahren entsprechend den allgemeinen Regeln umgewandelt werden. Dabei ist es beispielsweise möglich, eine Hilfseigenschaft in mehrere Hilfseigenschaften aufzuteilen, wobei die Aufteilung entsprechen der Zeit sein kann, um das Intervall der Hilfseigenschaft zu verkleinern, oder eine Unterteilung entsprechend den Anwendungsfällen sein kann, um eine Fallunterscheidung zu erreichen. Dabei werden kausale Abhängigkeiten zwischen den Teilen der Hilfseigenschaft eingeführt, die die chronologische Aktivierung der Teileigenschaften entsprechend ihrer zeitlichen Position innerhalb des Intervalls der kompletten Hilfseigenschaft garantiert. Die ermöglicht, dass bereits Teile einer Hilfseigenschaft aktiviert werden können, wenn bereits Teile von deren Voraussetzung aus der akkumulierten Voraussetzung erfüllt werden.

Zur Durchführung des Verfahrens werden insbesondere den einzelnen Signalen der Schaltung Symbole zugeordnet, die die Eingangsgrößen für das Verfahren bilden. Diese Größen beinhalten zunächst keine Information über Abhängigkeiten zwischen ihnen, die bei den Signalen in einer konkreten Schaltung in der Regel auftreten. So können sich beispielsweise zwei Zustände gegenseitig ausschließen, wenn beispielsweise der erste Zustand die Negation des zweiten Zustands ist. Diese Information ist zunächst bei den zugeordneten Symbolen nicht enthalten. Um diese Information jedoch bei der Durchführung des Verfahrens verfügbar zu machen, werden die logischen Abhängigkeiten zwischen den zugeordneten Symbolen gespeichert. Dies kann beispielsweise in der konjunktiven Normalform geschehen, bei der beispielsweise die Liste $[a_1, ..., a_m]$, $[b_1, ... , b_n]$, ... der logischen Funktion NOT $(a_1 \wedge ... \wedge a_m) \wedge$ NOT $(b_1 \wedge ... \wedge b_n) \wedge ...$ entspricht. Eine solche Abhängigkeit kann sich beispielsweise durch gegenseitigen Ausschluss zweier Zustände ergeben oder weil ein Zustand einen zweiten mit umfasst, wenn beispielsweise der erste Zustand nur angibt $x < 5$ und der zweite Zustand angibt $x = 2$, so dass der zweite Zustand den ersten Zustand notwendigerweise mit umfasst.

In einer besonders vorteilhaften Ausführungsform wird die vorliegende Erfindung verwendet, um eine zu beweisende Eigenschaft der Schaltung zu untersuchen. Die zu beweisende Eigenschaft wird im Folgenden als Beweisziel bezeichnet und besitzt ebenso wie die Hilfseigenschaften eine Voraussetzung und eine Behauptung. Ziel der Untersuchung ist es, das Beweisziel zu verifizieren, d.h. eine Aussage darüber zu treffen, ob die Eigenschaft zutrifft oder nicht zutrifft. Die Voraussetzung des Beweisziels wird als Startvoraussetzung verwendet und davon ausgehend unter Zuhilfenahme der Hilfseigenschaften die akkumulierte Voraussetzung gemäß dem erfindungsgemäßen Verfahren entwickelt. Dabei wird gleichzeitig überwacht, ob die akkumulierte Voraussetzung die Behauptung des Beweisziels umfasst. Wenn dies der Fall ist, kann somit bewiesen werden, dass bei Vorliegen der Voraussetzung des Beweisziels auch die Behauptung des Beweisziels zutreffend ist, und somit das Beweisziel verifiziert werden. Wenn dagegen bei der Entwicklung der akkumulierten Voraussetzung der Zustand eintritt, dass keine Hilfseigenschaft mehr aktiviert wird und die erzielte akkumulierte Voraussetzung die Behauptung des Beweisziels nicht umfasst, lässt sich das Beweisziel nicht folgern, da die Menge der vorgegebenen Hilfseigenschaften nicht ausreicht, um das Beweisziel zu entkräften. Der aktuelle Zustand der akkumulierten Voraussetzung und der reduzierten Behauptung des Beweisziels sowie der Aktivierungsmatrix geben gezielte Hinweise auf fehlende Hilfseigenschaften. Gegebenfalls kann das restliche Beweisziel durch einen modellbasierten Beweiser bewiesen werden. Wenn bei der Reduktion der Behauptung des Beweisziels der Fall eintritt, dass die restliche Behauptung im Widerspruch zur akkumulierten Voraussetzung steht, ist das Beweisziel widerlegt. In dem Fall lässt sich die Kette von Aktivierungen von Hilfseigenschaften zurückverfolgen, aus der der Widerspruch erzeugt wurde.

Die Erfindung wird nachfolgend anhand eines bevorzugten Ausführungsbeispiels unter Bezugnahme auf die beigefügten Zeichnungen näher erläutert.

Figur 1 zeigt ein zu beweisendes Beweisziel mit Voraussetzung und Behauptung,

Figur 2 zeigt drei Hilfseigenschaften jeweils mit Voraussetzung und Behauptung,

Figur 3 zeigt die akkumulierte Voraussetzung nach dem ersten Iterationsschritt, und

Figur 4 zeigt die akkumulierte Voraussetzung am Ende der Iteration.

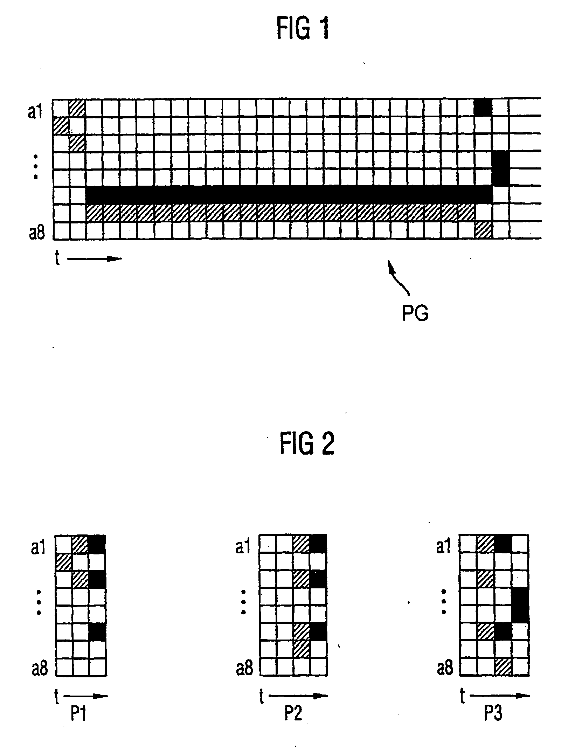

In Figur 1 ist ein zu beweisendes Beweisziel PG dargestellt. Das Beweisziel PG besitzt eine Voraussetzung und eine Behauptung, die jeweils über die Zeit t dargestellte Zustandsbeschreibungen einer Schaltung sind. Die Zeit t ist dabei in einzelne Zeitschritte unterteilt. Die Beschreibung des Schaltungszustands erfolgt durch binäre Werte einzelner Zustandsprädikate $a_1$-$a_8$, denen jeweils eine Zeile der in Figur 1 dargestellten Matrix zugeordnet ist. Im vorliegenden Ausführungsbeispiel soll eine bestimmte Eigenschaft PG eines Interruptcontrollers verifiziert werden, wobei zur Verifizierung des Beweisziels nur die Beobachtung von acht Zustandsprädikatenal-a8 erforderlich ist. Diese acht Zustandsprädikate al-a8 besitzen die folgenden Bedeutungen :

$$a_1 := data = \$d,\ a_2 := state = idle,\ a_3 := state = risc,\ a_4 := state = rdy,\ a_5 := req=0,\ a_6 := req =1,\ a_7 := ack=0,\ a_8 := ack=1.$$

In Figur 1. ist die Voraussetzung des Beweisziels PG gestrichelt und die Behauptung des Beweisziels PG mit schwarzen Flächen dargestellt. Ein leeres Kästchen bedeutet dabei FALSE bzw., dass ein Zustandsprädikat zu einem bestimmten relativen Zeitpunkt nicht zutrifft.

Das zu beweisende Beweisziel PG lässt sich in ITL wie folgt formulieren, wobei die Voraussetzung durch dieZeichen 1- von der Behauptung getrennt ist :

$$t_{req}=t+2,\ t_{ack}=t_{req}+23,$$

$$at\ t_{req}\text{-}2: state=idle,\ at\ t_{req}\text{-}1: state=risc \wedge data=\$d,$$

$$during\ [t_{req}, t_{ack}\text{-}1] : ack=0,$$

$$at\ t_{ack} : ack=1$$

$$|\text{-}\ \ during\ [t_{req}, t_{ack}] : req=1,\ at\ t_{ack} : data = \$d,$$

$$at\ t_{ack}+1 : req=0 \wedge state=rdy.$$

Die zeitlichen Bezugnahmen sind auf die erste Spalte links im Beweisziel PG bezogen, die den Zeitindex t besitzt, wobei darauffolgende Zeitschritte nach rechts aufgetragen sind. Das Beweisziel PG drückt somit aus, dass wenn zum Zeitpunkt t der Zustand idle ist, zum Zeitpunkt t+1 der Zustand risc ist und ein Datenwort data vorliegt, während der Zeitdauer t+2 bis t+24 ack=0 ist und bei t+25ack=1 ist, die Folge eintritt, dass während der Zeitdauer t+2 bis t+25 req=1 ist, bei t+25 ein Datenwort data vorliegt und beit+26 req=0 und der Zu- stand rdy ist.

In Figur 2 sind drei Hilfseigenschaften P1, P2, P3 dargestellt, die zum Verifizieren des Beweisziels PG verwendet werden sollen. Die drei Hilfseigenschaften P1-P3 enthalten ebenso jeweils eine Voraussetzung und eine Behauptung, die ebenso wie das Beweisziel PG Zustandsbeschreibungen der acht Zustandsprädikate $a_1$-$a_8$ umfassen. Ebenso sind die Voraussetzungen gestrichelt und die Behauptungen mit durchgängig schwarzen Flächen dargestellt und ist der zeitliche Bezugspunkt jeweils die Spalte am linken Rand.

Die drei Eigenschaften P1-P3 lassen sich wie folgt formulieren :

$$P1: \quad t_{req}=t+2,$$

$$\text{at } t_{req}\text{-2: state=idle, at } t_{req}\text{-1 : state=risc} \wedge \text{data=\$d}$$

$$\vdash \text{at } t_{req}\text{: state=risc} \wedge \text{data=\$d} \wedge \text{req=1}$$

$$P2: \quad t_{req}=t+2,$$

$$\text{at } t_{req}\text{: req=1} \wedge \text{state=risc} \wedge \text{data=\$d} \wedge \text{ack=0}$$

$$\vdash \text{at } t_{req}\text{+1: req=1} \wedge \text{state=risc} \wedge \text{data=\$d}$$

$$P3: \quad t_{ack}=t+2,$$

$$\text{at } t_{ack}\text{-1: req=1} \wedge \text{state=risc} \wedge \text{data=\$d}$$

$$\vdash \text{at } t_{ack}\text{: req=1} \wedge \text{data=\$d, at } t_{ack}\text{+1: req=0} \wedge \text{state=rdy}$$

Nun werden zusätzlich Hilfszustandsprädikate $c_1$-$c_5$ eingeführt, die jeweils Verknüpfungen der Zustandsprädikate $a_1$-$a_8$ wie folg darstellen:

$$c_1 := a_5 \wedge a_4, \ c_2 := a_3 \wedge a_1, \ c_3 := a_3 \wedge a_1 \wedge a_6, \ c_4 := a_6 \wedge a_3 \wedge a_1 \wedge a_7, \ c_5 := a_6 \wedge a_1.$$

Nach Einführung der Zustandsprädikate $a_1$-$a_8$ und der Hilfszustandsprädikate $c_1$-$c_5$ lassen sich das Beweisziel PG und die Hilfseigenschaften P1-P3 wie folgt ermitteln:

```
PG:
t_req=t+2, t_ack=t_req+23
at t_req-2: a₂; at t_req-1: a₃,
during [t_req, t_ack-1]: a₇,
at t_ack : a₈
|- during [t_req, t_ack]: a₆, at t_ack: a₁, at t_ack+1: c₁
```

```
P1:  t_req=t+2
     at t_req-2: a₂, at t_req-1: c₂
     |- at t_req: c₃
```

```
P2:  t_req=t+2
     at t_req: c₄
     |- at t_req+1: c₄
```

$$P3: \quad t_{ack}=t+2$$
$$at \ t_{ack}-1: \ c_4$$
$$at \ t_{ack}: \ a_8$$
$$\vdash at \ t_{ack}: \ c_5, \ at \ t_{ack}+1: \ c_1$$

Zusätzlich lassen sich aus den vorangegangenen Zustandsprädikaten $a_1$-$a_8$ und Hilfszustandsprädikaten $c_1$-$c_5$ die folgenden Zwischenbeziehungen in der konjunktiven Normalform (cnf) herstellen:

$[a_4, a_5, \neg c_1]$, $[-a_4, c_1]$, $[\neg a_5, c_1]$, $[a_1, a_3, \neg c_2]$, $[\neg a_1, c_2]$, $[\neg a_3, c_2]$, $[a_1, a_3, a_6, \neg c_3]$, $[\neg a_1, c_3]$, $[\neg a_3, c_3]$, $[\neg a_6, c_3]$, $[a_1, a_3, a_6,$ $a_7, \neg c_4]$, $[\neg a_1, c_4]$, $[\neg a_3, c_4]$, $[\neg a_6, c_4]$, $[\neg a_7, c_4]$, $[a_1, a_6, \neg c_5]$, $[\neg a_1, c_5]$, $[\neg a_6, c_5]$,

wobei $\neg$ eine Negierung bedeutet und die Konjunktion aller Elemente jeder Liste den Wahrheitswert Falsch ergibt. Beispielsweise schließen $\neg a_4$, $c_1$ einander aus, so dass aus dem Vorhandensein von $c_1$ die Bedingung $a_4$ gefolgert werden kann, ohne die im allgemeinen viel komplexere Definitionen dieser Symbole jedes Mal neu zu analysieren. Weiterhin lassen sich zwischen den Zustandsprädikaten $a_1$-$a_8$ die folgenden Beziehungen formulieren:

$[a_2, a_3]$, $[a_2, a_4]$, $[a_3, a_4]$, $[a_5, a_6]$, $[\neg a_5, \neg a_6]$, $[a_7, a_8]$, $[\neg a_7, \neg a_8]$.

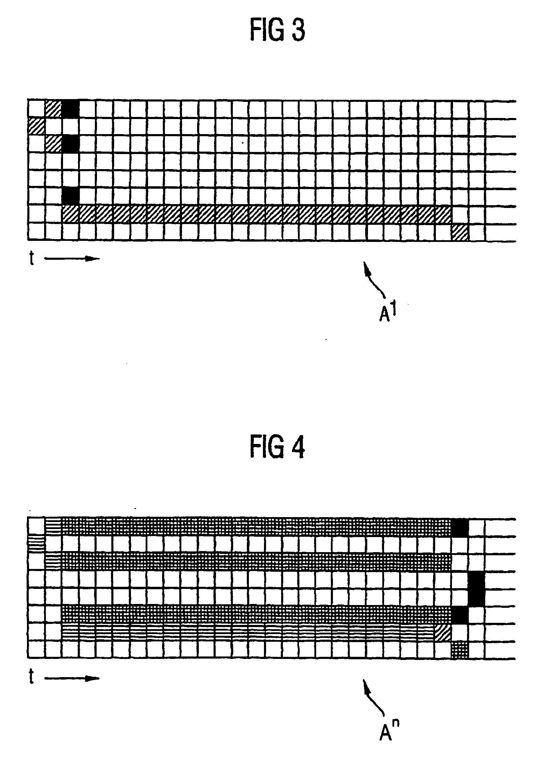

Zur Verifizierung des Beweisziels wird ausgegangen von der Voraussetzung des Beweisziels PG als Startvoraussetzung des Verfahrens, die in eine akkumulierte Voraussetzung A übernommen wird. In Figur 3 ist die akkumulierte Voraussetzung A in ihrem Zustand nach dem ersten Iterationsschritt dargestellt, so dass die Bezeichnung $A^1$ gewählt wird. Bei der in Figur 3 dargestellten akkumulierten Voraussetzung nach dem ersten Iterationsschritt ist bereits zusätzlich zu der Startvoraussetzung, die nur die gestrichelt dargestellten Kästchen umfasst, die Behauptung der ersten Hilfseigenschaft P1 hinzugekommen, die von den drei schwarzen Kästchen in der dritten Spalte gebildet wird. Diese sind in die akkumulierte Voraussetzung A eingetragen worden, da in den ersten beiden Spalten der Startvoraussetzung bereits die Voraussetzung der Hilfseigenschaft P1 enthalten war, so dass mit der Zeitverschiebung Null die Hilfseigenschaft P1 aktiviert worden ist und somit die Behauptung der Hilfseigenschaft P1 mit der Zeitverschiebung Null in die akkumulierte Voraussetzung A übernommen worden ist. Wie leicht zu erkennen ist, beinhaltet die in Figur 3 dargestellte akkumulierte Voraussetzung $A^1$ nach dem ersten Iterationsschritt durch das Hinzukommen der Behauptung der Hilfseigenschaft P1 nun auch die Voraussetzung der Hilfseigenschaft P2, so dass zu einem nächsten nicht dargestellten Iterationsschritt in der vierten Spalte die Behauptung der zweiten Hilfseigenschaft P2 hinzugefügt wird.

Auf diese Weise wird nacheinander iterativ der Zustand der akkumulierten Voraussetzung A weitergeführt und nach jeder Veränderung überprüft, ob die Voraussetzung eine Hilfseigenschaft P1-P3 gegeben ist und wenn ja, an welcher Stelle. Nach Aktivierung einer Hilfseigenschaft wird an gegebener Stelle in der akkumulierten Voraussetzung die Behauptung der jeweiligen Hilfseigenschaft hinzugefügt.

Vorab konnten bereits folgende Zwischenbeziehungen unter Berücksichtigung der Zeit zwischen den Hilfseigenschaften P1-P3 ermittelt werden, wobei $E_n$ das Enablen bzw. Aktivieren der Hilfseigenschaft n und $D_n$ das Disablen bzw. Deaktivieren der Hilfseigenschaft n kennzeichnet:

$$[E_1(t), \ \neg D_1(t-1)], \ [E_1(t), \ \neg D_1(t+1)], \ [E_1(t), \ \neg D_1(t+2)],$$

$$[E_1(t), \ \neg D_2(t-2)], \ [E_1(t), \ \neg D_3(t-1)], \ [E_2(t), \ \neg D_1(t+2)],$$

$$[E_2(t), \ \neg D_1(t+3)], \ [E_2(t), \ \neg D_3(t)],$$

$$[E_3(t), \ \neg D_1(t+1)], \ [E_3(t), \ \neg D_1(t+2)], \ [E_3(t), \ \neg D_2(t)],$$

$$[E_3(t), \ \neg D_2(t+1)], \ [E_3(t), \ \neg D_3(t+2)].$$

Am Ende der Durchführung des erfindungsgemäßen Verfahrens wird eine akkumulierte Voraussetzung $A^n$ erzielt, die in Figur 4 dargestellt ist. Die darin eingezeichneten Aktivierungen der einzelnen Zustandsprädikate sind wie folgt zu lesen. Waagrecht gestrichelte Kästchen kennzeichnen Zustandsprädikate, die bereits in der Startvoraussetzung enthalten waren und als Voraussetzung einer Hilfseigenschaft P1-P3 gedient haben. Quadratisch gemusterte Kästchen kennzeichnen Zustandsprädikate, die von einer Behauptung einer Hilfseigenschaft P1-P3 stammen und als Voraussetzung für eine Hilfseigenschaft P1-P3 gedient haben. Schwarze Kästchen kennzeichnen Zustandsprädikate, die aus einer Behauptung einer Hilfseigenschaft, im vorliegenden Fall P3, stammen und keine Voraussetzung zur Aktivierung einer Hilfseigenschaft P1-P3 gebildet haben.

Daneben gibt es ein Kästchen, das schräg schraffiert ist und aus der Startvoraussetzung stammt, jedoch nicht als Voraussetzung zur Aktivierung einer Hilfseigenschaft P1-P3 verwendet worden ist. Somit kann festgestellt werden, dass zum Erreichen der Behauptung des Beweisziels PG mittels der Hilfseigenschaften P1-P3 dieses schräg schraffierte Kästchen bzw. Zustandsprädikat nicht erforderlich war.

Das Verfahren wurde beim Zustand $A^n$ abgebrochen, da die akkumulierte Voraussetzung A die Behauptung des Beweisziels PG umfasst. Ferner wäre das Verfahren abgebrochen worden, sobald keine Hilfseigenschaft P1-P3 mehr hätte aktiviert werden können, so dass sich die akkumulierte Voraussetzung A nicht mehr hätte verändern können. In letzterem Fall wäre die Menge der Hilfseigenschaften unvollständig gewesen.

Grundsätzlich ist es auch möglich, dass die Behauptung der zu beweisenden Eigenschaft PG wenigstens zum Teil rückwärts durch die Voraussetzung einer Hilfseigenschaft ersetzt wird, aus deren Behauptung wenigstens ein Teil der Behauptung der zu beweisenden Eigenschaft PG folgt. Auf diese Weise kann das Verfahren abgekürzt werden, da aus dem Vorliegen der Voraussetzung einer solchen Hilfseigenschaft bereits das Eintreffen der rückwärts ersetzten Teile der Behauptung der zu beweisenden Eigenschaft PG gefolgert werden kann.

Daneben ist es auch möglich, dass die akkumulierte Voraussetzung einen Zustand einnimmt, der im Widerspruch zu der Behauptung des Beweisziels PG steht. In diesem Fall wäre das Beweisziel PG widerlegt, da die Behauptung des Beweisziels nicht mehr eintreffen kann.

## Patentansprüche

1. Verfahren zum Ermitteln des zeitlichen Verhaltens einer digitalen Schaltung ausgehend von einer Startvoraussetzung anhand wenigstens einer formalen Hilfseigenschaft (P1, P2, P3) der digitalen Schaltung, die für das Vorliegen einer Voraussetzung der wenigstens einen Hilfseigenschaft (P1, P2, P3) das Eintreffen einer, Behauptung der wenigstens einen Hilfseigenschaft (P1, P2, P3) angibt, wobei jede der wenigstens einen Hilfseigenschaften (P1, P2, P3) formal bewiesen ist, wobei die Startvoraussetzung, die Voraussetzung der wenigstens einen Hilfseigenschaft (P1, P2, P3) und die Behauptung der wenigstens einen Hilfseigenschaft (P1, P2, P3) Zustandsbeschreibungen der digitalen Schaltung sind, welche jeweils ein zeitliches Verhalten ausgewählter Schaltungsteile der digitalen Schaltung über die Zeit beschreiben derart, dass in den Zustandsbeschreibungen jeweils Schaltungs zustände über eine Anzahl von Zeitschritten erfasst sind, bei welchem Verfahren mit Hilfe von Daten verarbeitungsmitteln zu Beginn eine akkumulierte Voraussetzung (A), die ebenfalls eine Zustandsbeschreibung der digitalen Schaltung ist und ein zeitliches Verhalten der ausgewählten Schaltungsteile über die Zeit beschreibt, gleich der Startvoraussetzung gewählt wird, und in einer Voraussetzungsprüfung geprüft wird, ob die akkumulierte Voraussetzung (A) die Voraussetzung der wenigstens einen Hilfseigenschaft (P1, P2, P3) umfasst und bejahendenfalls die Behauptung dieser wenigstens einen Hilfseigenschaft (P1, P2, P3) in die akkumulierte Voraussetzung (A) aufgenommen wird,
   wobei die Startvoraussetzung die Voraussetzung einer zu beweisenden Eigenschaft (PG) der digitalen Schaltung ist und überprüft wird, ob eine Behauptung der zu beweisenden Eigenschaft (PG) der digitalen Schaltung von der akkumulierten Voraussetzung (A) umfasst ist, wobei
   eine Aktivierungsmatrix (M) erstellt wird, in der für
   jede der wenigstens einen Hilfseigenschaft (P1, P2, P3) für wenigstens einen Zeitverschiebungsschritt der wenigsten einen Hilfseigenschaft (P1, P2, P3) gegenüber der Startvoraussetzung ermittelt wird, ob die wenigstens eine Hilfseigenschaft (P1, P2, P3) aktiviert oder deaktiviert ist oder ob eine Aussage darüber noch nicht getroffen werden kann, wobei die wenigstens eine Hilfseigenschaft aktiviert wird, wenn die akkumulierte Vorraussetzung (A) die Voraussetzung der wenigstens einen Hilfseigenschaft (P1, P2, P3) umfasst und die wenigstens eine Hilfseigenschaft (P1, P2, P3) deaktiviert wird, wenn die wenigstens eine Hilfseigenschaft (P1, P2, P3) die akkumulierte Vorraussetzung (A) nicht umfasst.

2. Verfahren nach Anspruch 1, **dadurch gekennzeichnet,**
   **dass** die Voraussetzungsprüfung durchgerührt wird, sobald sich die aktuelle Voraussetzung (A) verändert hat.

3. Verfahren nach einem der vorangehenden Ansprüche,
   **dadurch gekennzeichnet,**
   **dass** wenigstens zwei Hilfseigenschaften vorliegen und

**dass** Zwischenbeziehungen zwischen den wenigstens zwei Hilfseigenschaften (P1, P2, P3) ermittelt werden, die anzeigen, in welcher Weise das Vorliegen der Voraussetzung einer ersten der wenigsten zwei Hilfseigenschaften (P1, P2, P3) das Vorliegen der Voraussetzung wenigstens einer anderen der wenigstens zwei Hilfseigenschaften (P1, P2, P3) in geeigneter Zeitverschiebung bedingt.

4. Verfahren nach Anspruch 3, **dadurch gekennzeichnet,**
   **dass** bei dem Ermitteln der Zwischenbeziehungen berücksichtigt wird, in welcher Weise die Behauptung der ersten der wenigstens zwei Hilfseigenschaften (P1, P2, P3) die Voraussetzung einer anderen der wenigstens zwei Hilfseigenschaften (P1, P3, P3) umfasst, und/oder in welcher Weise das Vorliegen einer Voraussetzung der ersten der wenigstens zwei Hilfseigenschaften (P1, P2, P3) das Vorliegen der Voraussetzung einer anderen der wenigstens zwei Hilfseigenschaften (P1, P2, P3) bedingt oder ausschließt.

5. Verfahren nach einem der vorhergehenden Ansprüche,
   **dadurch gekennzeichnet,**
   **dass** die wenigstens eine Hilfseigenschaft (P1, P2, P3) derart in Teilhilfseigenschaften (P1, P2, P3) unterteilt wird, dass die Summe der Behauptungen der Teilhilfseigenschaften (P1, P2, P3) der Behauptung der wenigstens einen Hilfseigenschaft (P1, P2, P3) entspricht und die Summe der Voraussetzungen der Teilhilfseigenschaften (P1, P2, P3) der Voraussetzung der wenigstens einen Hilfseigenschaft (P1, P2, P3) entspricht und bei der Aktivierung einer der Teilhilfseigenschaften kausale Abhängigkeiten der Teilhilfseigenschaften untereinander in Form einer festgelegten Aktivierungsreihenfolge berücksichtigt werden.

6. Verfahren nach Anspruch 5, **dadurch gekennzeichnet,**
   **dass** eine Beweisaufgabe durch automatische und kontrollierte Fallunterscheidungen aufgeteilt wird, wenn **dadurch** wenigstens eine Hilfseigenschaft (P1, P2, P3) aktiviert wird, wobei für jeden Fall der Fallunterscheidung eine eigene akkumulierte Voraussetzung, eine eigene Aktivierungsmatrix und eine eigene entsprechend reduzierte Behauptung erzeugt wird.

7. Verfahren nach Anspruch 5 oder 6,
   **dadurch gekennzeichnet,**
   **dass** das Verfahren abgebrochen wird, wenn in einem ersten Fall die akkumulierte Voraussetzung (A) keine Voraussetzung einer der wenigstens zwei Hilfseigenschaften (P1, P2, P3) umfasst und die Anreicherung der akkumulierten Voraussetzung mit Teilbedingungen aus Fallunterscheidungen keine Aktivierung von einer der wenigstens zwei Hilfseigenschaften bewirkt, wenn in einem zweiten Fall die Behauptung des Beweisziels vollständig entkräftet worden ist, wenn in einem dritten Fall alle der wenigstens zwei Hilfseigenschaften (P1, P2, P3), die noch bei geeigneter Zeitverschiebung aktiviert werden können, außerhalb des Zeitfensters des Beweisziels liegen, oder wenn in einem vierten Fall die auf einen Zeitpunkt bezogenen Teile der Aktivierungsmatrix identisch zu auf einen früheren Zeitpunkt bezogenen Teile sind, deren Aktivierungszustand sich nicht mehr verändern lässt.

8. Verfahren nach einem der vorhergehenden Ansprüche, **dadurch gekennzeichnet,**
   **dass** eine Behauptung der zu beweisenden Eigenschaft (PG) rückwärts ersetzt wird durch die Voraussetzung der wenigstens einen Hilfseigenschaft (P1, P2, P3), aus deren Behauptung die Behauptung der zu beweisenden Eigenschaft (PG) folgt.

9. Verfahren nach einem der vorhergehenden Ansprüche,
   **dadurch gekennzeichnet,**
   **dass** alle in allen Voraussetzungen und Behauptungen vorkommenden Zustandsprädikate durch eindeutige uninterpretierte Symbole ersetzt werden, deren logische Abhängigkeiten untereinander durch einmalig syntaktisch und semantisch vorab generierte Regeln bei den Schlussfolgerungen zur Bestimmung der Aktivierbarkeit von Hilfseigenschaften oder bei der Prüfung, ob eine Behauptung zutrifft, nicht zutrifft oder ob das Zutreffen der Behauptung offen ist, berücksichtigt werden.

10. Verfahren nach einem der vorhergehenden Ansprüche,
    **dadurch gekennzeichnet,**
    **dass** die kausale Abhängigkeit der Hilfseigenschaften, die nacheinander aktiviert worden sind, aus der Abfolge der Aktivierungen abgeleitet werden.

11. Verfahren nach Anspruch 10, **dadurch gekennzeichnet,**
    **dass** Inkonsistenzen zwischen einer Behauptung und der akkumulierten Voraussetzung (A) in der Kette aktivierter der wenigstens zwei Hilfseigenschaften (P1, P2, P3) zurückverfolgt werden und in Abhängigkeit der akkumulierten Voraussetzung (A), wenigstens einer Behauptung, und der aktuellen Aktivierungsmatrix Hinweise für mögliche Vervollständigungen der Menge wenigstens zwei Hilfseigenschaften (P1, P2, P3) erzeugt werden.

12. Vorrichtung zum Ermitteln des zeitlichen Verhaltens einer digitalen Schaltung, ausgehend von einer Startvoraussetzung anhand wenigstens einer formalen Hilfseigenschaft (P1, P2, P3) der digitalen Schaltung, die für das Vorliegen einer Voraussetzung der wenigstens einen Hilfseigenschaft (P1, P2, P3) das Eintreffen einer Behauptung der wenigstens einen Hilfseigenschaft (P1, P2, P3) angibt, wobei jede der wenigstens einen Hilfseigenschaften (P1, P2, P3) formal bewiesen ist, wobei die Startvoraussetzung, die Voraussetzung der wenigstens einen Hilfseigenschaft (P1, P2, P3) und die Behauptung der wenigstens einen Hilfseigenschaft (P1, P2, P3) Zustandsbeschreibungen der digitalen Schaltung sind, welche jeweils ein zeitliches Verhalten ausgewählter Schaltungsteile über die Zeit beschreiben derart, dass in den Zustandsbeschreibungen jeweils Schaltungs zustände über eine Anzahl von Zeitschritten erfasst sind, wobei die Vorrichtung Datenverarbeitungsmittel umfasst, die derart eingerichtet sind, dass sie zu Beginn eine akkumulierte Voraussetzung (A), die ebenfalls eine Zustandsbeschreibung der digitalen Schaltung ist und ein zeitliches Verhalten der ausgewählten Schaltungsteile der digitalen Schaltung über die Zeit beschreibt, zu Beginn gleich der Startvoraussetzung wählt, in einer Voraussetzungsprüfung prüft, ob die akkumulierte Voraussetzung (A) die Voraussetzung der wenigstens einen Hilfseigenschaft (P1, P2, P3) umfasst und bejahendenfalls die Behauptung dieser wenigstens einen Hilfseigenschaft (P1, P2, P3) in die akkumulierte Voraussetzung (A) aufnimmt,

wobei die Startvoraussetzung die Voraussetzung einer zu beweisenden Eigenschaft (PG) der digitalen Schaltung ist und überprüft wird, ob eine Behauptung der zu beweisenden Eigenschaft (PG) der digitalen Schaltung von der akkumulierten Voraussetzung (A) umfasst ist, wobei

eine Aktivierungsmatrix (M) erstellt wird, in der für

jede der wenigstens einen Hilfseigenschaft (P1, P2, P3) für wenigstens einen Zeitverschiebungsschritt der wenigsten einen Hilfseigenschaft (P1, P2, P3) gegenüber der Startvoraussetzung ermittelt wird, ob die wenigstens eine Hilfseigenschaft (P1, P2, P3) aktiviert oder deaktiviert ist oder ob eine Aussage darüber noch nicht getroffen werden kann, wobei die wenigstens eine Hilfseigenschaft aktiviert wird, wenn die akkumulierte Vorraussetzung (A) die Voraussetzung der wenigstens einen Hilfseigenschaft (P1, P2, P3) umfasst und die wenigstens eine Hilfseigenschaft (P1, P2, P3) deaktiviert wird, wenn die wenigstens eine Hilfseigenschaft (P1, P2, P3) die akkumulierte Vorraussetzung (A) nicht umfasst.

13. Vorrichtung nach Anspruch 12, **dadurch gekennzeichnet,**
**dass** die Vorrichtung zur Durchführung eines Verfahrens nach einem der Ansprüche 1 bis 11 eingerichtet ist.

## Claims

1. A method for determining the temporal behavior of a digital circuit based on a starting assumption using at least one formal auxiliary property (P1, P2, P3) of the digital circuit, which indicates for the presence of an assumption of the at least one formal auxiliary property (P1, P2, P3), the occurrence of an assertion of the at least one formal auxiliary property (P1, P2, P3), wherein each of the at least one auxiliary properties (P1, P2, P3) is formally proven, wherein the starting assumption, the assumption of the at least one formal auxiliary property (P1, P2, P3), and the assertion of the at least one formal auxiliary property (P1, P2, P3) are state descriptions of the digital circuit that each describe a temporal behavior of selected circuit portions of the digital circuit over time, such that the state descriptions each comprise states of the circuit over a number of time intervals, the method comprising, using data processing means, selecting at the beginning an accumulated assumption (A) that also is a state description of the digital circuit and that describes a temporal behavior of selected portions of the digital circuit, to be equal to the starting assumption, and checking in an assumption test, whether the accumulated assumption (A) comprises the assumption of the at least one auxiliary property (P1, P2, P3), and, if this is the case, including the assertion of this at least one auxiliary property (P1, P2, P3) into the accumulated assumption (A), wherein the starting assumption is the assumption of a property of the digital circuit that is to be proven (PG) and wherein it is checked whether the accumulated assumption (A) comprises an assertion of the property of the digital circuit that is to be proven (PG), wherein an activation matrix (M) is generated, in which it is determined for each of the at least one auxiliary property (P1, P2, P3) for at least one time shift interval of the at least one auxiliary property (P1, P2, P3) with respect to the starting assumption, if the at least one auxiliary property (P1, P2, P3) is activated or deactivated, or whether a determination can not yet be made, wherein the at least one auxiliary property is activated if the accumulated assumption (A) comprises the assumption of the at least one auxiliary property (P1, P2, P3), and the at least one auxiliary property (P1, P2, P3) is deactivated if the at least one auxiliary property (P1, P2, P3) does not comprise the accumulated assumption (A).

2. The method of claim 1, **characterized in that** the assumption test is performed when the current assumption (A) is modified.

3. The method of any of the preceding claims, **characterized in that** at least two auxiliary properties are provided and that interrelationships between the at least two auxiliary properties (P1, P2, P3) are determined that indicate, in which way the presence of the assumption of a first one of the at least two auxiliary properties (P1, P2, P3) involves the presence of the assumption of a further one of the at least two auxiliary properties (P1, P2, P3) in an adequate time shift.

4. The method of claim 3, **characterized in that** it is taken into account, when determining the interrelationships, in which way the assertion of the first one of the at least two auxiliary properties (P1, P2, P3) comprises the assumption of a further one of the at least two auxiliary properties (P1, P2, P3), and/or in which way the presence of an assumption of the first one of the at least two auxiliary properties (P1, P2, P3) involves or excludes the presence of the assumption of a further one of the at least two auxiliary properties (P1, P2, P3).

5. The method of any of the preceding claims, **characterized in that** the at least one auxiliary property (P1, P2, P3) is divided into auxiliary sub-properties (P1, P2, P3) such that the combination of the assertions of the auxiliary sub-properties (P1, P2, P3) corresponds to the assertion of the at least one auxiliary property (P1, P2, P3), and the combination of the assumptions of the auxiliary sub-properties (P1, P2, P3) corresponds to the assumption of the at least one auxiliary property (P1, P2, P3), and mutual causal dependencies of the auxiliary sub-properties are taken into account in the form of a pre-defined activation sequence when one auxiliary sub-property is acitvated.

6. The method of claim 5, **characterized in that** an objective that is to be proven is apportioned by automatic and controlled case differentiations, if this causes the activation of at least one auxiliary property (P1, P2, P3), wherein an individual accumulated assumption, an individual activation matrix and an individual, correspondingly reduced assertion is generated for each case of the case differentiation.

7. The method of claim 5 or 6, **characterized in that** the method is terminated, if, in a first case, the accumulated assumption (A) does not comprise an assumption of any of the at least two auxiliary properties (P1, P2, P3) and the enhancement of the accumulated assumption with partial conditions from case differentiations does not cause an activation of one of the at least two auxiliary properties, if, in a second case, the assertion of the objective that is to be proven has been completely invalidated, if, in a third case, each of the at least two auxiliary properties, which may still be activated at a suitable time shift, are located outside a time window of the objective that is to be proven, or if, in a forth case, parts of the activation matrix relating to a first time are identical to parts at an earlier time, the state of activation of which may no longer be modified.

8. The method of any of the preceding claims, **characterized in that** an assertion of the property that is to be proven (PG) is backwardly replaced by the assumption of that at least one auxiliary property (P1, P2, P3), that comprises the assertion from which the assertion that is to be proven results.

9. The method of any of the preceding claims, **characterized in that** all of the state grades occurring in any assumption and any assertion are replaced by distinct non-interpreted symbols, the logical mutual dependencies of which are taken into account by pregenerated unique syntactic and semantic rules, at the conclusions for the determination of activatability of auxiliary properties or by the test, whether an assumptions applies, does not apply, or whether the applications of the assumption is outstanding.

10. The method of any of the preceding claims, **characterized in that** the causal dependency of the auxiliary properties that have been subsequently activated is determined from the sequence of activations.

11. The method of claim 10, **characterized in that** inconsistencies between an assertion and the accumulated assumption (A) in the chain of activated ones of the at least two auxiliary properties (P1, P2, P3) are traced back and hints for possible completion of the set of the least two auxiliary properties (P1, P2, P3) are generated depending on the accumulated assumption (A), on at least one assumption and on the current activation matrix.

12. An apparatus for determining the temporal behavior of a digital circuit based on a starting assumption using at least one formal auxiliary property (P1, P2, P3) of the digital circuit, which indicates for the presence of an assumption of the at least one formal auxiliary property (P1, P2, P3), the occurrence of an assertion of the at least one formal auxiliary property (P1, P2, P3), wherein each of the at least one auxiliary properties (P1, P2, P3) is formally proven, wherein the starting assumption, the assumption of the at least one formal auxiliary property (P1, P2, P3), and the assertion of the at least one formal auxiliary property (P1, P2, P3) are state descriptions of the digital circuit that each describe a temporal behavior of selected circuit portions of the digital circuit over time, such that the state descriptions each comprise states of the circuit over a number of time intervals, wherein the apparatus comprises data processing means that are adapted to select at the beginning an accumulated assumption (A) that also is a state description of the digital circuit and that describes a temporal behavior of selected portions of the digital circuit, to be initially equal to the starting assumption, to check in an assumption test, whether the accumulated assumption (A) comprises the assumption of the at least one auxiliary property (P1, P2, P3), and if this is the case, to include the assertion of this at least one auxiliary property (P1, P2, P3) into the accumulated assumption (A), wherein the starting assumption is the assumption of a property of the digital circuit that is to be proven (PG) and wherein it is checked, whether the accumulated assumption (A) comprises an assertion of the property of the digital circuit that is to be proven (PG), wherein an activation matrix (M) is generated, in which it is determined for each of the at least one auxiliary property (P1, P2, P3) for at least one time shift interval of the at least one auxiliary property (P1, P2, P3) with respect to the starting assumption, if the at least one auxiliary property (P1, P2, P3) is activated or deactivated, or whether a determination can not yet be made, wherein the at least one auxiliary property is activated if the accumulated assumption (A) comprises the assumption of the at least one auxiliary property (P1, P2, P3), and the at least one auxiliary property (P1, P2, P3) is deactivated if the at least one auxiliary property (P1, P2, P3) does not comprise the accumulated assumption (A).

13. The apparatus of claim 12, **characterized in that** the apparatus is adapted to perform the method of any of the claims 1 to 11.

## Revendications

1. Procédé de détermination du comportement temporel d'un circuit numérique, en partant d'une hypothèse de départ à l'aide d'au moins une propriété auxiliaire formelle (P1, P2, P3) du circuit numérique, qui déclare l'arrivée d'une assertion de la au moins une propriété auxiliaire (P1, P2, P3) pour l'existence d'une hypothèse de la au moins une propriété auxiliaire (P1, P2, P3 ), chacune des au moins une propriété auxiliaire (P1, P2, P3) étant établie formellement, dans lequel l'hypothèse de départ, l'hypothèse de la au moins une propriété auxiliaire (P1, P2, P3) et l'assertion de la au moins une propriété auxiliaire (P1, P2, P3) sont des descriptions d'état du circuit numérique, qui décrivent respectivement un comportement temporel de parties de circuit choisies du circuit numérique, dans le temps, de sorte que, dans les descriptions d'état, respectivement, des états de circuit sont détectés sur une quantité de tranches temporelles, dans lequel procédé une hypothèse cumulée A, qui est aussi une description d'état du circuit numérique et qui décrit un comportement temporel des parties de circuit choisies dans le temps, est choisie, au début égale à l'hypothèse de départ, et on vérifie dans un test d'hypothèse, si l'hypothèse cumulée (A) comprend l'hypothèse d'au moins une propriété auxiliaire (P1, P2, P3) et dans l'affirmative, l'assertion de cette au moins une propriété auxiliaire (P1, P2, P3) est intégrée dans l'hypothèse cumulée A, à l'aide de moyens de travail de données,
dans lequel l'hypothèse de départ est l'hypothèse d'une propriété à démontrer (PG) du circuit numérique et on vérifie si une assertion de la propriété à vérifier (PG) du circuit numérique est comprise dans l'hypothèse cumulée (A), dans lequel
une matrice d'activation (M) est créée, dans laquelle, pour chacune des au moins une propriété auxiliaire (P1, P2, P3), pour au moins un pas de déplacement temporel des au moins une propriété auxiliaire (P1, P2, P3) vis-à-vis de l'hypothèse de départ, on détermine si la au moins une propriété auxiliaire (P1, P2, P3) est activée ou désactivée ou si une assertion à ce sujet ne peut pas encore être trouvée, la au moins une propriété auxiliaire étant activée lorsque l'hypothèse cumulée A comprend l'hypothèse de la au moins une propriété auxiliaire (P1, P2, P3), et la au moins une propriété auxiliaire (P1, P2, P3) étant désactivée lorsque la au moins une propriété auxiliaire (P1, P2, P3) ne comprend pas l'hypothèse cumulée (A).

2. Procédé selon la revendication 1, **caractérisé en ce que** le test d'hypothèse est réalisé aussitôt que l'hypothèse en cours (A) s'est modifiée.

3. Procédé selon l'une quelconque des revendications précédentes, **caractérisé en ce qu'**au moins deux propriétés auxiliaires existent, et **en ce que** des relations intermédiaires entre les au moins deux propriétés auxiliaires (P1, P2, P3) sont déterminées, qui montrent dans quelle mesure l'existence de l'hypothèse d'une première parmi les au moins deux propriétés auxiliaires (P1, P2, P3) entraîne l'existence de l'hypothèse d'au moins une autre des au moins deux propriétés auxiliaires (P1, P2, P3) dans un déplacement temporel approprié.

4. Procédé selon la revendication 3, **caractérisé en ce que**, lors de la détermination des relations intermédiaires, on fait intervenir dans quelle mesure l'assertion de la première des au moins deux propriétés auxiliaires (P1, P2, P3) comprend l'hypothèse d'une autre des au moins deux propriétés auxiliaires (P1, P2, P3), et/ou dans quelle mesure l'existence d'une hypothèse de la première des au moins deux propriétés auxiliaires (P1, P2, P3) entraîne ou ferme l'existence de l'hypothèse d'une autre des au moins deux propriétés auxiliaires (P1, P2, P3).

5. Procédé selon l'une quelconque des revendications précédentes, **caractérisé en ce que** la au moins une propriété auxiliaire (P1, P2, P3) est divisée en propriété auxiliaire par partie (P1, P2, P3) de sorte que la somme des assertions des propriétés auxiliaires par partie (P1, P2, P3) correspond à l'assertion de la au moins une propriété auxiliaire (P1, P2, P3) et la somme des hypothèses des propriétés auxiliaires par partie (P1, P2, P3) correspond à l'hypothèse de la au moins une propriété auxiliaire (P1, P2, P3), et par l'activation d'une des propriétés auxiliaires par partie, on vérifie des dépendances causales des propriétés auxiliaires par partie les unes aux autres sous la forme d'une séquence d'activation prédéterminée.

6. Procédé selon la revendication 5, **caractérisé en ce qu'**une tâche de détermination est distribuée à travers des distinctions de cas automatiques et contrôlées lorsqu'au moins une propriété auxiliaire (P1, P2, P3) est activée, dans lequel, pour chaque cas de distinction de cas, une hypothèse cumulée propre, une matrice d'activation propre, et une assertion réduite correspondante propre sont engendrées.

7. Procédé selon la revendication 5 ou 6, **caractérisé en ce que** le procédé est interrompu lorsque, dans un premier cas, l'hypothèse cumulée (A) ne comprend pas d'hypothèse de l'une des au moins deux propriétés auxiliaires (P1, P2, P3), et la concentration de l'hypothèse, cumulée avec des conditions par partie provenant des distinctions de cas, ne produit pas d'activation de l'une des au moins deux propriétés auxiliaires, lorsque, dans un deuxième cas, l'assertion du but de détermination est complète, lorsque dans un troisième cas, l'ensemble des au moins deux propriétés auxiliaires (P1, P2, P3) qui peuvent encore être activées par le déplacement temporel approprié, se trouve en dehors de la fenêtre de temps du but de détermination, ou , lorsque dans un quatrième cas, les parties relatives à un point temporel de la matrice d'activation sont identiques à des parties relatives à un point temporel antérieur, dont l'état d'activation ne se laisse plus modifier.

8. Procédé selon l'une quelconque des revendications précédentes, **caractérisé en ce qu'**une assertion de la propriété à vérifier (PG) est établie en arrière par l'hypothèse de la au moins une propriété auxiliaire (P1, P2, P3), dont l'assertion suit l'assertion de la propriété à vérifier (PG).

9. Procédé selon l'une quelconque des revendications précédentes, **caractérisé en ce que** tous les prédicats d'état intervenant dans les hypothèses et les assertions sont remplacés par des symboles non interprétés univoques, dont les dépendances logiques les uns aux autres interviennent par des règles générées antérieurement sémantiques et syntaxiques uniques, dans les conclusions de la détermination de la capacité d'activation des propriétés auxiliaires ou dans la vérification de si une assertion est vérifiée, non vérifiée ou si la vérification de l'assertion est incertaine.

10. Procédé selon l'une quelconque des revendications précédentes, **caractérisé en ce que** la dépendance causale des propriétés auxiliaires, qui sont activées les unes après les autres, est déduite de la suite d'activation.

11. Procédé selon la revendication 10, **caractérisé en ce que** des inconsistances entre une assertion et l'hypothèse cumulée (A) sont remontées dans la chaîne activée des au moins deux propriétés auxiliaires (P1, P2, P3), et des notes explicatives sont élaborées pour documentation possible de l'ensemble des au moins deux propriétés auxiliaires (P1, P2, P3) en fonction de l'hypothèse cumulée (A), d'au moins une assertion et de la matrice d'activation en cours.

12. Dispositif de détermination du comportement temporel d'un circuit numérique, en partant d'une hypothèse de départ, à l'aide d'au moins une propriété auxiliaire formelle (P1, P2, P3) du circuit numérique, qui indique l'arrivée d'une assertion de la au moins une propriété auxiliaire (P1, P2, P3) pour l'existence d'une hypothèse de la au moins une propriété auxiliaire (P1, P2, P3), chacune des au moins une propriétés auxiliaires (P1, P2, P3) étant établie formellement, dans lequel l'hypothèse de départ, l'hypothèse de la au moins une propriété auxiliaire (P1, P2, P3) et l'assertion de la au moins une propriété auxiliaire (P1, P2, P3) sont des descriptions d'état du circuit numérique, qui décrivent respectivement un comportement temporel de parties de circuit choisies dans le temps, de sorte que, dans les descriptions d'état, respectivement des états du circuit numérique sont détectés sur une quantité de tranches temporelles, dans lequel le dispositif comprend des moyens de travail de données, qui sont agencés pour choisir au début une hypothèse cumulée (A), qui est en particulier une description d'état du circuit numérique et qui décrit un comportement temporel de la partie de circuit choisie du circuit numérique dans le temps, pour vérifier dans un test d'hypothèse si l'hypothèse cumulée (A) comprend l'hypothèse de la au moins une propriété auxiliaire (P1, P2, P3), et, dans l'affirmative, si l'insertion de cette au moins une propriété auxiliaire (P1, P2, P3) est comprise dans l'hypothèse cumulée (A),

dans lequel l'hypothèse de départ est l'hypothèse d'un propriété à démontrer (PG) du circuit numérique, et on vérifie si une assertion de la propriété à vérifier (PG) du circuit numérique est comprise dans l'hypothèse cumulée (A), dans lequel une matrice d'activation (M) est créée, dans laquelle

pour chacune des au moins une propriétés auxiliaires (P1, P2, P3) pour au moins un pas de déplacement temporel de la au moins une propriété auxiliaire (P1, P2, P3) vis-à-vis de l'hypothèse de départ, on détermine si la au moins une propriété auxiliaire (P1 P2, P3) est activée ou désactivée ou si une logique à ce sujet ne peut pas encore être trouvée, la au moins une propriété auxiliaire étant activée, lorsque l'hypothèse cumulée (A) comprend l'hypothèse de la au moins une propriété auxiliaire (P1, P2, P3), et la au moins une propriété auxiliaire (P1,P2, P3) étant désactivée, lorsque la au moins une propriété auxiliaire (P1, P2, P3) ne comprend pas l'hypothèse cumulée (A).

**13.** Dispositif selon la revendication 12, **caractérisé en ce que** le dispositif est agencé pour réaliser un procédé selon l'une quelconque des revendications 1 à 11.

## FIG 1

## FIG 2

# FIG 3

t ⟶

$A^1$

# FIG 4

t ⟶

$A^n$